# EUROPEAN PATENT APPLICATION

(11) **EP 1 884 501 A1**
(43) Date of publication of application: **06.02.2008**
(21) Application number: 06017675.7
(22) Date of filing: 24.08.2006
(51) Int. Cl.: C03C 17/245, C03C 17/00, C07F 7/22, C23C 16/40

(54) **Method and formulation for depositing a metal-containing coating on a substrate**

(30) Priority: 28.07.2006 US 495806
(71) Applicant: Gulbrandsen Chemicals, Inc., Orangeburg SC 29115 (US)
(72) Inventor: Coney, Stuart, Snaith, East Yorkshire DN 149RA (GB)
(74) Representative: Maiwald Patentanwalts GmbH

(57) **Abstract**

The present invention is in the field of methods and formulations for applying a protective coating onto a substrate, and more particularly, methods and formulations for applying a protective coating by application of a metal compound onto the hot glass surfaces using a chemical-vapor deposition (CVD) technique, in which a liquid coating comprising the organic metal compound, water and a lower alkyl alcohol is used as reactant.

## Description

### BACKGROUND OF THE INVENTION

The desirability of applying protective coatings to glass in general, and to the exterior of hollow glass containers in particular, has long been recognized. Such coatings, which include those resulting from the application of tin, titanium or other heat-decomposable inorganic and organic metal compounds, have been disclosed to protect the glass surface from damage such as from abrasion and scratches which can be unsightly and may cause a loss of tensile strength. The need for high tensile strength in, for example, glass containers is particularly acute when the containers are mass-produced, moved rapidly in close proximity along highspeed conveyors, and are subsequently filled with beverages, foodstuffs, and the like, particularly those which are carbonated or can produce gaseous pressure within the container.

Protective coatings are often applied to glass articles, such as sheet glass, glass containers and the like, when they emerge from a forming machine in a heated, fully-shaped condition, that is, at the "hot" end of the glass making process. The containers are thereafter transported from the forming machine to a coating area by a conveyor. Temperatures, often in excess of 600 degrees C, exist at the surface of the glass containers so that when a heat decomposable metal containing compound is applied to those surfaces, the compound decomposes and/or otherwise converts to a protective coating, e.g., a metallic-oxide film coating.

U.S. Patent No. 3,819,346 (the '346 Patent) discloses a coating process using an inorganic tin compound, such as tin chloride. As discussed therein, it was allegedly difficult to ensure formation of a uniform coating using prior art processes because the vapor containing metal compounds used reacted too quickly with moisture in the atmosphere before contacting the glass surface. The result was non-uniform coating thickness and poor container-to-container reproducibility. Moreover, the loss of the metal compound through such a premature reaction reduced the efficiency and increased the expense of the process. The presence of excess water, even a small amount in the atmosphere, was therefore detrimental. The '346 Patent purports to overcome these problems by spraying a liquid solution containing stannic chloride pentahydrate and a solvent, such as water or a lower alcohol, onto a heated glass surface directly instead of applying a vapor. The '346 Patent suggests that spraying the liquid solution rather than applying the vapor onto a substrate provides greater control over the thickness and height of the resulting coating. Moreover, this specific inorganic metal containing compound was sufficiently nonreactive with water to allow it to be applied as a solution. In general, however, spray applications, as the one taught in the '346 Patent, are still inefficient and do not yield high-quality uniform films.

U.S. Patent No. 4,261,722 (the '722 Patent) purports to improve the methods described in the '346 Patent and other inorganic metal based processes. The '722 Patent discusses problems of these types of prior art processes, including the fact that the tin halide vapor stream (if a vapor phase is used) is extremely vulnerable to moisture in the atmosphere causing non-uniform coating thickness and inefficiency of the method. With respect to spraying the liquid solution described in the '346 Patent, the '722 Patent states that such processes still remain inefficient and therefore not commercially viable.

The '722 Patent proposes an improved method wherein separate streams of a vapor containing a metal compound and a water vapor are directed onto the surface of the heated glass through separate nozzles. It seeks to avoid premature reaction by keeping the inorganic tin compound separate from the water until application. This method requires that the two nozzles be in close proximity, preferably not greater than 2.5 cm from the glass surface to limit the time of contact of the vapor containing metal compounds with the water vapor. However, the distance requirement between the vapor nozzles and the substrate of this method is cumbersome and impractical for a commercial coating process.

U.S. Patent No. 5,004,490 (the '490 Patent) discloses the use of an organic metal containing compound, such as monobutyltin trichloride (MBTC), instead of an inorganic compound in a spray application as described in some of the processes mentioned earlier. The '490 Patent teaches that organic metal containing compounds, such as MBTC, can be mixed with an alcohol, such as methanol or butanol, which is then sprayed onto a substrate using a spray gun. These are generally anhydrous products and the coating process can still be influenced by atmospheric moisture. The '490 Patent describes that the use of MBTC results in an application of a thicker coating than that of an inorganic compound, such as butyltin methoxide or butyltin butoxide. As mentioned above, however, liquid spray applications as opposed to chemical-vapor deposition (CVD) techniques, are inefficient and do not yield high-quality uniform films. Moreover, there is no teaching or suggestion in the '490 Patent to mix water with an organic metal compound, such as MBTC, in making a coating composition.

Therefore, there is still a great need to develop a simple, economical and more efficient coating process in applying a protective coating onto a substrate using the CVD technique.

### SUMMARY OF THE INVENTION

Generally, the present invention relates to methods and formulations for applying a protective coating onto a substrate, and more particularly, methods and formulations for applying a protective coating by applying a metal containing organic compound onto the hot glass surfaces using a chemical-vapor deposition (CVD) technique.

More specifically, in one embodiment, the present invention relates to a method for applying a protective coating onto a surface of a substrate comprising forming a vapor of a liquid coating composition comprising (a) about 10 to about 90 weight % of an organic metal compound, (b) about 5 to about 50 weight % of water and (c) about 5 to about 45 weight % of a lower alkyl alcohol, and contacting a substrate having a temperature of about or above the decomposition temperature of the organic metal compound with the vapor so as to provide a coating on at least a portion of said substrate.

In accordance with one aspect of the invention, the substrate is at or above the decomposition temperature of the organic metal compound. Generally, the temperature of the substrate is at least about 500°C, preferably at least about 600°C.

In accordance with some aspects of the invention, the method of applying a protective coating has an improved efficiency compared to a prior art process using prior art coating solutions. The liquid coating compositions described above and the coated substrates made using same are also contemplated.

In accordance with another aspect of the invention, there is provided a liquid coating composition for providing a highly efficient coating process for applying a protective coating onto a substrate comprising (a) about 10 to about 90 weight % of an organic metal compound, (b) about 5 to about 50 weight % of water, and (c) about 5 to about 45 weight % of lower alkyl alcohol. In a particularly preferred embodiment, whatever the weight % of organic metal compound, the ratio of the weight % of water to the weight % of lower alkyl alcohol should be in the range of about 1:1 to about 2:1. The preferred range for this ratio is about 1.1:1 to about 1.5:1.

The present invention is a significant advance. It allows for the use of the CVD methods, yet, it is insensitive to and indeed benefits from the presence of moisture in the surrounding atmosphere and/or in the formation itself. Indeed, the liquid coating composition of the present invention is formulated with water, even though many inorganic and organic tin containing compounds are unstable in the presence of water. The liquid coating composition of the present invention, despite the high water content, is also storage stable at room temperature. Moreover, the present invention provides a much higher efficiency, which reduces cost and waste.

### DETAILED DESCRIPTION

Throughout the entire specification, including the claims, the word "comprise" and variations of the word, such as "comprising" and "comprises," as well as "have," "having," "includes," "include" and "including," and variations thereof, means that not only the named steps, elements or materials to which it refers, form a construct within the scope of the claim or disclosure but also other steps, elements or materials which may be added still form a construct within the scope of the claim or disclosure. When recited in describing the invention and in a claim, it means that the invention and what is claimed is considered to what follows and potentially more. These terms, particularly when applied to claims, are inclusive or open-ended and do not exclude additional, unrecited elements or methods steps. The term "between" as used in connection with a range includes the endpoints unless the context suggests otherwise. All references to testing are at room temperature (20-25°C) unless otherwise specified and all references to temperature are in degrees centigrade unless otherwise specified.

In describing the preferred embodiments of the present invention, specific terminology will be resorted to for the sake of clarity. However, the invention is not intended to be limited to the specific terms so selected, and is understood that each specific term includes all technical equivalence which operate in a similar manner to accomplish the same purpose.

The term "alkyl" used herein includes a straight chain, branched, or cyclic group comprised of carbon and hydrogen having 1 to 24 carbon atoms. These may be substituted with halogens, hydroxyl groups, sulfur or nitrogen containing group, esters, ethers, and the like. The term "lower alkyl" used herein includes any alkyl group explained above having 1 to 6 carbon atoms.

The term "organic metal compound(s)" or "organic metal containing compound(s)" used herein includes a compound that contains both an organic group and a metal. The organic group includes a collection of atoms comprised essentially of carbon and hydrogen, however, other elements, such as nitrogen, sulfur, silicon or oxygen, may also be present. These organic groups include, without limitation, hydrocarbons (such as alkanes, alkenes, alkynes, dienes, arenes), alkyl halides, alkenyl halides, aryl halides, alcohols, phenols, epoxides, aldehydes, ketone, carboxylic acids, acyl halids, acid anhydrides, esters, amides, amines, nitriles, nitro compounds., thiols, and sulfides. Of these, alkyl halides are preferred. The metal includes metals belonging to groups 3, 4, 5, and 6 of the Periodic tables. These include Ti, Si, B, Ta, Nb, Zr, Sn, Sr, Al, In or a mixture thereof. The most preferred metal compounds contain Sn and Ti, and, thus, the term "organic metal compound(s)" used herein preferably includes "organic tin compound(s)" and "organic titanium compound(s)." The organic metal compounds used herein may also include salt formers and/or counterions.

The term "substrate" used herein includes glass such as glass containers, sheet glass, ceramics, plastics, metals, and mixtures thereof.

The term "overall efficiency" used herein is defined as the ratio between the amount of elemental metal deposited to the substrate and the amount of elemental metal introduced for the purpose of coating. For example, in a typical prior art coating process for glass bottles, it is expected that about 4 kg of monobutyltin trichloride (MBTC) are required to deposit 37 c.t.u. (coating thickness unit) of metal oxide film onto 209,000 glass bottles (20 Oz.). The amount of elemental metal (i.e., tin) present in 4 kg of monobutyltin trichloride is 1.65 kg. At 37 c.t.u., the amount of elemental metal (i.e., tin) actually deposited on the glass bottles is calculated to be 0.47 kg. Therefore, the overall efficiency of a typical prior art coating process is 0.47 kg/1.65 kg (the amount of elemental metal deposited/the amount of elemental metal introduced), which is about 28% overall efficiency.

In a preferred embodiment, the methods and compositions of the present invention are used in a so-called "hot-end coating" for substrates in general and glass containers in particular. The hot end of a glass making process is where the molten glass is formed into a container in a forming machine. In a forming machine, a stream of molten glass at its plastic temperature (1050°C to 1200°C) is cut by shearing blade to form a cylinder of glass. Then the glass is eventually blown into the mold to make the final container shape. The forming process, occurring over a short period of time (6-20 seconds), leaves the container with internal stresses which then need to be relieved through annealing. An annealing oven (known in the industry as a Lehr) first heats the container up to 580°C then cools it, depending on the glass thickness, over a 20-60 minute period.

Applying protective coatings to the exterior of glass containers are accomplished in a so-called "hood" after the containers emerge from the forming machine and before entering the annealing Lehr. Of course, they can be applied in an analogous place in other processes. Hoods, which isolate the glass containers from some ambient conditions, are well known and widely used for applying a protective coating to hot glass containers. Coating hoods substantially representative of the prior art are disclosed in U.S. Patent Nos. 3,819,404, 3,933,457, 4,389,234 and 5,140,940.

The hood generally has at least one feed point to introduce the liquid coating composition of the present invention, and blowers to move the vapors of the liquid coating composition across the containers to form a film on the surface of the hot glass containers. The hood also includes an exhaust system which captures most of the air-entrained coating compound not adhering to the containers.

The liquid coating composition of the present invention is in the form of liquid at the room temperature, which may be vaporized and applied in a hood as described or in some other manner. The vaporized form of the liquid coating composition of the present invention is formed by the known methods in the art, normally by pumping or otherwise moving the liquid coating composition into a chamber where it contacts a stream of heated air at between about 80°C to about 200°C. Accordingly, the temperature of the vapor containing the organic metal compound is between about 80 to about 200°C. This vapor is subsequently directed at the substrate to be coated.

This vapor is contacted to the glass containers in the hood as explained above to apply a protective coating onto the containers which are preferably at about or above the decomposition temperature of the organic metal compound. Generally, the temperature of the containers is at least about 500°C, preferably at least about 600°C.

The preferred hood used in accordance with the present invention is the Gulbrandsen GE series of coating system(s), manufactured by Gulbrandsen Chemicals Inc. However, comparable results should be obtained from other systems including most of those in current usage by the glass container industry. While the foregoing was described in the context of glass containers, it generally applies equally well to other substrates and, in particular, sheet glass.

In another embodiment of the present invention, the substrate (e.g. glass container) can be a preexisting and preformed container that was previously produced, cooled, and even used. An already manufactured container can be heated to a temperature as disclosed herein and a liquid coating composition of the present invention applied as a vapor.

Unlike the teaching of the prior art references that many inorganic tin and organic tin compounds are extremely vulnerable to moisture causing inefficiency of the method, the inventors of the present invention surprisingly discovered a highly efficient liquid coating composition which is formulated with water, indeed about 5 to about 50 weight % of water. In fact, it has been discovered that having about 5 to about 50 weight % of water in a liquid coating composition not only unexpectedly improved the overall efficiency of the CVD coating process, but also allowed the process to be relatively insensitive to the presence of moisture in the surrounding atmosphere as well. These formulations, despite the high water content, are also storage stable at room temperature. By "storage stable," it is meant that the prepared compositions of the present invention are able to be stored at room temperature for at least 3 months, more preferably about 6 months, and even more preferably at least about one year without substantial deterioration so that it can still be used as a coating composition. Employing water in a solvent system allows the coating process of the present invention to be simple and economical compared to the prior art processes.

Other additives may be put into the mixture at any time (i.e., during, before or after the organic metal compound is introduced) to the mixture, providing they do not cause an adverse reaction so that the liquid coating composition deteriorates and cannot be used as a coating composition.

In a preferred embodiment, the liquid coating composition of the present invention comprises (a) about 10 to about 90 weight % of an organic metal compound, (b) about 5 to about 50 weight % of water, and (c) about 5 to about 45 weight % of an alkyl alcohol relative to the total liquid coating composition. Preferably, the liquid coating composition of the present invention comprises (a) about 20 to about 80 weight % of an organic metal compound, (b) about 10 to about 45 weight % of water, and (c) about 10 to about 40 weight % of an alkyl alcohol relative to the total weight of the liquid coating composition. More preferably, the liquid coating composition of the present invention comprises (a) about 30 to about 65 weight % of an organic metal compound, (b) about 15 to about 35 weight % of water, and (c) about 15 to about 35 weight % of an alkyl alcohol relative to the total weight of the liquid coating composition.

In yet another preferred embodiment, the liquid coating composition of the present invention comprises (a) about 10 to about 90 weight % of an organic tin compound, (b) about 5 to about 50 weight % of water, and (c) about 5 to about 45 weight % of a lower alkyl alcohol relative to the total liquid coating composition. Preferably, the liquid coating composition of the present invention comprises (a) about 25 to about 75 weight % of an organic tin compound, (b) about 15 to about 40 weight % of water, and (c) about 10 to about 35 weight % of a lower alkyl alcohol relative to the total weight of the liquid coating composition. More preferably, the liquid coating composition of the present invention comprises (a) about 40 to about 60 weight % of an organic tin compound, (b) about 20 to about 30 weight % of water, and (c) about 15 to about 30 weight % of a lower alkyl alcohol relative to the total weight of the liquid coating composition. The foregoing is based on monobutyltin trichloride (MBTC) as the organic tin compound. These weights will vary with the weights of other tin compounds used. However, they should provide the same range of elemental tin regardless of which organic tin-containing compound is used.

In another preferred embodiment, the liquid coating composition of the present invention further comprises about 1 x 10⁻⁸ to about 20 weight % of an additive, preferably about 1 x 10⁻⁶ to about 5 weight % relative to the total weight of the liquid coating composition.

Examples of the organic metal compound which can be used in accordance with the present invention include, but are not limited to, organic tin compounds and organic titanium compounds.

Non-limiting examples of organic tin compounds which can used in accordance with the present invention include, but are not limited to, an alkyltin trichloride, dialkyltin dichloride, an alkyldichlorotin acetate, an alkylchlorotin diacetate, monobutyltin trichloride, isobutyltin trichloride, methyltin trichloride, dibutyltin dichloride, diisobutyltin dichloride, di-t-butyltin dichloride, butyldichlorotin acetate, butylchlorotin diacetate, carbethoxyethyltin trichloride, and a mixture thereof. Of these, monobutyltin trichloride is the preferred organic tin compound.

Non-limiting examples of organic titanium compounds which can be used in accordance with the present invention include, but are not limited to, tetra (C1-C18) alkoxy titanate, methyl triethoxy titanium (iv), methyl titanium (iv) triisopropoxide, methyl titanium (iv) tributoxide, methyl titanium (iv) tri-t-butoxide, isopropyl titanium (iv) tributoxide, butyl titanium (iv) triethoxide, butyl titanium (iv) tributoxide, phenyl titanium (iv) triisopropoxide, phenyl titanium (iv) tributoxide, phenyl titanium (iv) triisobutoxide, and a mixture thereof.

Non-limiting examples of water which can be used in accordance with the present invention include, but are not limited to, tap water, filtered water, distilled water, deionized water and a mixture thereof. Of these, distilled and deionized water are preferred.

Non-limiting examples of lower alkyl alcohols which can be used in accordance with the present invention include, but are not limited to, methanol, ethanol, isopropanol, pentanol, n-propanol, t-butanol and a mixture thereof. Of these, methanol and ethanol are preferred.

Non-limiting examples of additives which can be used in accordance with the present invention include, but are not limited to, a coloring agent, an UV absorber, an UV inhibitor a pigment, a dye, a photochromic compound, and a mixture thereof. Of these, a coloring agent is the preferred additive.

The liquid coating composition of the present invention can be manufactured on-site by mixing various ingredients mentioned above, or can be prepackaged and sold in containers of various sizes and quantities. The liquid coating compositions of the present invention are preferably stable at room temperature for at least about 3 months, more preferably about 6 months, and even more preferably at least about one year.

The liquid coating composition of the present invention facilitates a highly efficient coating process for depositing a protective coating, such as metal oxide film, onto the substrates. Accordingly, the liquid coating composition of the present invention will provide an increase in efficiency over that obtained under the same conditions, using the same equipments and facility using any prior art protective coating solution based on either inorganic or organic tin compounds. Specifically, the present invention significantly increase the overall efficiency of the coating process by at least about 10% compared to the prior art processes using prior art coating solutions.

This amounts to a considerable cost savings to the industry since a much lower amount of the expensive organic metal compounds is wasted during the coating process. By using a lower amount of organic metal compounds and by producing less amount of organic metal compound waste, the present invention also will enhance the quality of the environment.

A CTU is a well known measure of the thickness of the coating by the American Glass Research Institute of Butler, Pa. One CTU unit is approximately equal to 2.2 Angstrom units. One Angstrom unit is equal to 10⁻⁸ cm. When a glass container is determined to have a coating thickness of, for example, 35 c.t.u., it is understood by one of ordinary skill in the art that the coating thickness on the main body of the glass container will provide good scratch and damage resistance to the glass surface after the cold end coating is applied.

In a preferred embodiment, the thickness of the protective coating formed by contacting a vapor of the liquid coating composition of the present invention onto a hot surface of a substrate is from about 10 c.t.u. to about 100 c.t.u., preferably from about 30 c.t.u. to about 50 c.t.u.

The following examples illustrate the subject matter of the invention in further details.

EXAMPLE 1

Glass Bottles (20 Oz.) coming out the continuous forming process were contacted for about between 18 and about 21 hours with vapors of various liquid coating compositions as shown below including a commercial prior art MBTC coating material as a control example. The liquid coating compositions of the present invention (Samples 2 and 3) were produced by forming an alcohol-water solution first, then adding MBTC to the solution.

| Material | MBTC (wt %) | Water (wt %) | Methanol (wt %) | Total (wt %) |
|---|---|---|---|---|
| Sample 1: commercial MBTC coating material (G-Coat-H110) | 98 | <50 p.p.m. | 2 | 100 |
| Sample 2: liquid coating composition of the present invention containing high MBTC content | 62.5 | 20.2 | 17.3 | 100 |
| Sample 3: liquid coating composition of the present invention containing low MBTC content | 44.4 | 30.0 | 25.6 | 100 |

The results of these experiments are summarized in tabular form as follows:

| | Overall Efficiency (%) | Coating Thickness (c.t.u.) | Temperature of vaporized coating material (°C) | Substrate Temperature (°C) |
|---|---|---|---|---|
| Sample 1 | 22.9 | 37.2 | 200 | 650 |
| Sample 2 | 26.2 | 40.5 | 200 | 650 |
| Sample 3 | 37.2 | 42.5 | 200 | 650 |

- Sample 2, which is the liquid coating composition of the present invention containing high MBTC content, increased the overall efficiency of the coating process by about 14%.
- Sample 3, which is the liquid coating composition of the present invention containing low MBTC content, increased the overall efficiency of the coating process by about 62%.

These results were obtained using a bottle forming machine operating speed overtime at 145 b.p.m. The amount of tin on bottle was calculated using publicly available information on deposited material per c.t.u. per unit area, area of bottles made and chemical weights. The information is provided in a paper by F. Geotti- Bianchini et al., Evaluation of tin oxide coatings on glass containers using HECM and EPMA, Glass Technology, vol. 35. No. 5 (Oct. 1994). The equipment used to run Example 1 is tabulated below:

| Resource | Description |
|---|---|
| Bottle making equipment | 8IS section double gob - ran at 145 b.p.m. |
| Hot End Coating equipment | Arkema C3-42" long |
| Bottle | Amber 20oz beer-coated area 367.6 cm² |

EXAMPLE 2

Glass jars (250 ml) coming out of the continuous forming machine were contacted with vapors for about 4 hours with various liquid coating compositions as shown below including a commercial prior art MBTC coating material as a control sample. The liquid coating composition of the present invention (Sample 5) was produced by forming an alcohol-water solution first, then adding MBTC to the solution.

| Material | MBTC (wt %) | Water (wt %) | Methanol (wt %) | Total (wt %) |
|---|---|---|---|---|
| Sample 4: commercial MBTC coating material (G-Coat-H110) | 98 | <50 p.p.m. | 2 | 100 |
| Sample 5: liquid coating composition of the present invention containing medium MBTC content | 58.9 | 22.2 | 18.9 | 100 |

The results of these experiments are summarized in tabular form as follows:

| | Overall Efficiency (%) | Coating Thickness (c.t.u.) | Temperature of vaporized coating material (°C) | Substrate Temperature (°C) |
|---|---|---|---|---|
| Sample 4 | 44.7 | 31.7 | 150 | 650 |
| Sample 5 | 74.8 | 39.7 | 150 | 650 |

- Sample 5, which is the liquid coating composition of the present invention containing medium MBTC content, increased the overall efficiency of the coating process by about 68%.

These results were obtained using a bottle forming machine operating speed overtime at 150 b.p.m. The amount of tin on bottle was calculated using publicly available information on deposited material per c.t.u. per unit area, area of bottles made and chemical weights. The information is provided in a paper by F. Geotti- Bianchini et al., Evaluation of tin oxide coatings on glass containers using HECM and EPMA, Glass Technology, vol. 35. No. 5 (Oct. 1994).

The equipment used to run Example 1 is tabulated below:

| Resource | Description |
|---|---|
| Bottle making equipment | 8IS section double gob - ran at 150 b.p.m. |
| Hot End Coating equipment | Vidromecânica VSQR - 1200 mm long |
| Bottle | Flint 250 ml jar - coated area 179.5 cm² |

EXAMPLE 3

The liquid coating compositions of the following formulations were also tested. The results showed an improvement in the overall efficiency of the coating process by at least about 10% compared to a prior art MBTC coating process.

| No. | MBTC (weight %) | Methanol (weight %) | Water (weight %) | Total |
|---|---|---|---|---|
| Sample 6 | 53 | 15 | 17 | 100 |
| Sample 7 | 50 | 16 | 19 | 100 |
| Sample 8 | 47 | 17 | 20 | 100 |
| Sample 9 | 45 | 18 | 22 | 100 |
| Sample 10 | 42 | 19 | 23 | 100 |
| Sample 11 | 38 | 22 | 25 | 100 |

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the spirit and scope of the present invention as defined by the appended claims.

## Claims

1. A liquid coating composition comprising:
(a) about 10 weight % to about 90 weight % of an organic metal compound,
(b) about 5 weight % to about 50 weight % of water, and
(c) about 5 weight % to about 45 weight % of a lower alkyl alcohol.

2. The liquid coating composition of claim 1, wherein said organic metal compound is an organic tin compound, an organic titanium compound, or a mixture thereof.

3. The liquid coating composition of claim 2, wherein said organic tin compound is monobutyltin trichloride.

4. The liquid coating composition of claim 1, wherein said water is tap, filtered, distilled, deionized water or a mixture thereof.

5. The liquid coating composition of claim 1, wherein said lower alkyl alcohol is methanol, ethanol or a mixture thereof.

6. The liquid coating composition of claim 1, further comprising an additive.

7. The liquid coating composition of claim 1, wherein said liquid coating composition is storage stable at room temperature for at least about 3 months.

8. The liquid coating composition of claim 7, wherein said liquid coating composition is storage stable at room temperature for about 6 months.

9. The liquid coating composition of claim 1, wherein said liquid coating composition provides an improved overall efficiency.

10. A substrate coated with the liquid coating composition of claim 1.

11. A method for applying the liquid coating composition of claim 1 onto a surface of a substrate comprising:
forming a vapor of the liquid coating composition of claim 1, and contacting a substrate having a temperature of at least about the decomposition temperature of said organic metal compound with said vapor so as to provide a coating on at least a portion of said substrate.

12. The method of claim 11, wherein said organic metal compound is an organic tin compound.

13. The method of claim 12, wherein said organic tin compound is monobutyltin trichloride.

14. The method of claim 11, wherein said organic metal compound is an organic titanium compound.

15. The method of claim 11, wherein said water is tap, filtered, distilled, deionized water or a mixture thereof.

16. The method of claim 11, wherein said lower alkyl alcohol is ethanol, methanol or a mixture thereof.

17. The method of claim 11, wherein said substrate is a glass.

18. The method of claim 17, wherein said glass is a glass container or a sheet glass.

19. The method of claim 11, wherein said organic metal compound is present in an amount ranging from about 20 weight % to about 80 weight % with respect to the total weight of said liquid coating composition.

20. The method of claim 11, wherein said water is present in an amount ranging from about 10 weight % to about 45 weight % with respect to the total weight of said liquid coating composition.

21. The method of claim 11, wherein said lower alkyl alcohol is present in an amount ranging from about 10 weight % to about 40 weight % with respect to the total weight of said liquid coating composition.

22. The method of claim 11, wherein said temperature of said substrate is about 500°C or more.

23. The method of claim 11, wherein said step of contacting said substrate with said vapor provides an improved overall efficiency.

24. The method of claim 11, wherein said liquid coating composition further comprises an additive.

25. The method of claim 11, wherein said liquid coating composition is storage stable at room temperature for at least 3 months.

26. The method of claim 25, wherein said liquid coating composition is storage stable at room temperature for at least 6 months.

27. The method of claim 11, wherein said liquid coating composition comprises
(a) about 25 weight % to about 75 weight % of monobutyltin trichloride,
(b) about 15 weight % to about 40 weight % of water, and
(c) about 10 weight % to about 35 weight % of methanol, and said temperature of said substrate is about 500°C or more.
